(19) **Europäisches Patentamt European Patent Office Office européen des brevets**

(11) **EP 2 486 659 B1**

(12) **FASCICULE DE BREVET EUROPEEN**

(45) Date de publication et mention de la délivrance du brevet:
**25.11.2020 Bulletin 2020/48**

(21) Numéro de dépôt: **10781948.4**

(22) Date de dépôt: **01.10.2010**

(51) Int Cl.:
*H03M 7/40* (2006.01)     *H04N 19/196* (2014.01)
*H04N 19/436* (2014.01)    *H04N 19/91* (2014.01)

(86) Numéro de dépôt international:
**PCT/FR2010/052081**

(87) Numéro de publication internationale:
**WO 2011/042645 (14.04.2011 Gazette 2011/15)**

(54) **PROCEDES DE CODAGE ET DE DÉCODAGE D'IMAGES, DISPOSITIFS DE CODAGE ET DE DECODAGE ET PROGRAMMES D'ORDINATEUR CORRESPONDANTS**

VERFAHREN ZUR CODIERUNG UND DECODIERUNG VON BILDERN, ZUGEHÖRIGE CODIER- UND DECODIERVORRICHTUNGEN SOWIE COMPUTERPROGRAMM

METHODS FOR ENCODING AND DECODING IMAGES, CORRESPONDING ENCODING AND DECODING DEVICES AND COMPUTER PROGRAMS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.10.2009 FR 0956932**

(43) Date de publication de la demande:
**15.08.2012 Bulletin 2012/33**

(73) Titulaire: **ORANGE**
**75015 Paris (FR)**

(72) Inventeurs:
• PATEUX, Stéphane
  F-35700 Rennes (FR)
• AMONOU, Isabelle
  F-35510 Cesson Sevigne (FR)
• CAMMAS, Nathalie
  F-35490 Sens De Bretagne (FR)

(74) Mandataire: **Vidon Brevets & Stratégie**
**16B, rue de Jouanet**
**BP 90333**
**35703 Rennes Cedex 7 (FR)**

(56) Documents cités:
EP-A2- 1 355 499     FR-A1- 2 854 754
FR-A1- 2 931 280     US-A1- 2004 258 162
US-A1- 2008 074 426  US-A1- 2008 219 349

• XUN GUO ET AL: "Ordered Entropy Slices for Parallel CABAC", 37. VCEG MEETING; 15-4-2009 - 18-4-2009; YOKOHAMA, JP; (VIDEO CODINGEXPERTS GROUP OF ITU-T SG.16),, no. VCEG-AK25, 2 May 2009 (2009-05-02), XP030003677, ISSN: 0000-0085

**Description**

**1. Domaine de l'invention**

Le domaine de l'invention est celui du codage et du décodage d'images, et notamment de flux vidéo constitués d'une série d'images successives.

L'invention peut ainsi, notamment, s'appliquer au codage vidéo mis en œuvre dans les codeurs vidéo actuels (MPEG, H.264, etc) ou à venir (ITU-T/VCEG (H.265) ou ISO/MPEG (HVC).

**2. Art antérieur**

Les codeurs vidéo actuels (MPEG, H264, ...) utilisent une représentation par blocs de la séquence vidéo. Les images sont découpées en macro-blocs, chaque macro-bloc est lui-même découpé en blocs et chaque bloc, ou macro-bloc, est codé par prédiction intra-images ou inter-images. Ainsi, des images I sont codées par prédiction spatiale (prédiction intra), des images P et B sont codées par prédiction temporelle par rapport à d'autres images I, P ou B codées-décodées à l'aide d'une compensation en mouvement. De plus, pour chaque bloc est codé un bloc résiduel correspondant au bloc original diminué d'une prédiction. Les coefficients de ce bloc sont quantifiés après une éventuelle transformation, puis codés par un codeur entropique.

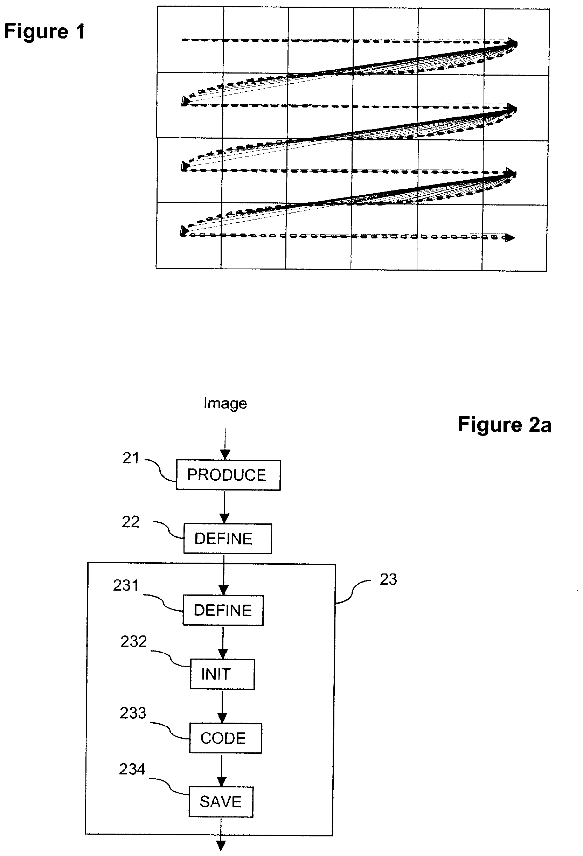

On s'intéresse ici plus particulièrement au codeur entropique. Le codeur entropique encode les informations suivant leur ordre d'arrivée. Typiquement un parcours ligne par ligne des blocs est réalisé, de type « raster-scan », comme illustré sur la figure 1, en partant du bloc en haut à gauche de l'image. Pour chaque bloc, les différentes informations nécessaires à la représentation du bloc (type de bloc, mode de prédiction, coefficients de résidu, ...) sont envoyées séquentiellement au codeur entropique.

On connaît déjà un codeur arithmétique efficace et de complexité raisonnable, appelé « CABAC » ("Context Adaptive Binary Arithmetic Coder" en anglais), introduit dans le standard de compression AVC (aussi connu sous le nom de ISO-MPEG4 partie 10 et ITU-T H.264).

Ce codeur entropique met en œuvre différents concepts :

- le codage arithmétique : le codeur, tel que décrit initialement dans le document J. Rissanen and G. G. Langdon Jr, "Universal modeling and coding," IEEE Trans. Inform. Theory, vol. IT-27, pp. 12-23, Jan. 1981, utilise, pour coder un symbole, une probabilité d'apparition de ce symbole ;
- l'adaptation au contexte : il s'agit ici d'adapter la probabilité d'apparition des symboles à coder. D'une part, un apprentissage à la volée est réalisé. D'autre part, suivant l'état des informations préalablement codées, un contexte spécifique est utilisé pour le codage. A chaque contexte correspond une probabilité d'apparition propre du symbole. Par exemple un contexte correspond à un type de symbole codé (la représentation d'un coefficient d'un résidu, signalisation de mode de codage, ...) et suivant une configuration donnée, ou un état du voisinage (par exemple le nombre de modes « intra » sélectionnés dans le voisinage, ...) ;
- la binarisation : une mise sous la forme d'une suite de bits des symboles à coder est réalisée. Par la suite, ces différents bits sont envoyés successivement au codeur entropique binaire.

Ainsi, ce codeur entropique met en œuvre, pour chaque contexte utilisé, un système d'apprentissage des probabilités à la volée par rapport aux symboles précédemment codés pour le contexte considéré. Cet apprentissage est basé sur l'ordre de codage de ces symboles. Typiquement, l'image est parcourue selon un ordre de type « raster-scan », décrit ci-dessus.

Du fait de l'utilisation d'un tel ordre de parcours, ce codeur entropique présente plusieurs inconvénients.

En effet, on peut observer un manque d'adéquation locale de l'apprentissage des probabilités, dû au type de parcours. Par exemple, lors du codage d'un symbole se situant en début d'une ligne, les probabilités utilisées correspondent principalement à celles observées pour les symboles se situant en fin de la ligne précédente. Or, du fait de la possible variation spatiale des probabilités des symboles (par exemple pour un symbole lié à une information de mouvement, le mouvement situé sur la partie droite d'une image peut être différent de celui observé sur la partie gauche et donc de même pour les probabilités locales en découlant), ce manque d'adéquation locale des probabilités entraîne une perte en efficacité lors du codage.

Pour limiter ce phénomène, des propositions de modifications de l'ordre de parcours des blocs ont été faites, dans le but d'assurer une meilleure cohérence locale, mais le codage et le décodage restent séquentiels.

C'est un deuxième inconvénient de ce type de codeur entropique. En effet, le codage et le décodage d'un symbole étant dépendants de l'état de la probabilité apprise jusque-là, le décodage des symboles ne peut se faire que dans le même ordre que celui utilisé lors du codage. Typiquement, le décodage ne peut alors être que séquentiel, empêchant ainsi un décodage en parallèle de plusieurs symboles (par exemple pour profiter des architectures multi-cœur).

Le document de brevet US2009168868A1, intitulé « Systems and apparatuses for performing cabac parallel encoding and decoding », décrit une méthode permettant un type de parallélisation du codage et/ou du décodage dans un codeur de type « CABAC ».

Selon un premier mode de réalisation décrit dans ce document, certaines étapes mises en œuvre dans le codeur peuvent être effectuées en parallèle, par exemple la binarisation et la définition des contextes, pour un même élément de syntaxe, ou symbole. Ce mode de réalisation ne permet pas un réel parallélisme de décodage de plusieurs symboles, car la contrainte de décodage séquentiel reste présente.

Selon un second mode de réalisation, une image est découpée en tranches, appelées « slices », et le codeur « CABAC » est initialisé à chaque début de slice, afin d'optimiser l'initialisation des probabilités. Ce mode de réalisation permet un décodage en parallèle des slices, mais l'initialisation du codeur à chaque nouvelle slice diminue fortement les performances du codeur. Le manque d'adéquation locale des probabilités est donc ici encore renforcé.

Il existe donc un besoin pour une nouvelle technique de codage entropique d'une séquence de symboles représentative d'une image ou d'une série d'images, permettant notamment d'offrir un décodage non séquentiel des symboles codés, sans perte de performances de compression.

## 3. Exposé de l'invention

L'invention propose une solution nouvelle qui ne présente pas l'ensemble de ces inconvénients de l'art antérieur, sous la forme d'un procédé de codage d'au moins une image, procédé de codage défini par la revendication 1.

Ainsi, l'invention repose sur une approche nouvelle et inventive du codage d'images, et plus particulièrement du codage entropique, permettant à la fois un apprentissage plus efficace des probabilités d'apparition des symboles pour le codage et un décodage en parallèle des symboles codés.

En effet, l'invention prend en compte, pour le codage des symboles de la sous-séquence courante, un voisinage "multidimensionnel" ou groupe voisin codé, comprenant au moins deux sous-séquences précédemment codées, pour une meilleure adéquation locale des probabilités d'apparition des symboles et donc un apprentissage des probabilités plus efficace.

En outre, l'invention détermine les voisinages des sous-séquences à coder, de façon à garantir l'existence d'au moins deux sous-séquences, la sous-séquence courante et la sous-séquence distincte non encore codée, qui sont indépendantes pour le décodage et donc aptes à être décodées par des décodeurs fonctionnant en parallèle.

L'invention propose également une mise en commun d'une partie de voisinage de ces sous-séquences indépendantes pour le décodage, de façon à propager les probabilités d'apparition entre elles et ainsi partager des connaissances des probabilités acquises au fur et à mesure du codage.

L'invention réalise enfin un stockage des probabilités d'apparition associées à chacun des contextes utilisés pour le codage des symboles de la sous-séquence courante, à la fin de son codage, de façon à pouvoir les prendre en considération lors d'un codage ultérieur d'une autre sous-séquence.

Le stockage des probabilités liées au codage des symboles d'une sous-séquence, à la fin du codage de cette dernière, peut être vu comme un « point de synchronisation » dans le codage, servant ensuite au décodage. En effet, un décodeur "parallèle" pourra avantageusement initialiser les probabilités d'apparition des symboles d'une sous-séquence à décoder en au moins deux de ces points de synchronisation.

Selon un aspect particulier de l'invention, l'étape de génération d'une séquence de symboles est obtenue à l'aide d'un codage par blocs, et le regroupement prédéterminé de symboles est un regroupement de blocs de taille fixe, noté par la suite « super-bloc ».

Dans ce cas, les points de synchronisation correspondent aux probabilités stockées liées aux contextes utilisés pour le codage des symboles de chaque super-bloc codé de l'image.

En particulier, ledit groupe voisin codé courant est situé dans un rectangle délimité d'une part par le premier bloc codé de l'image selon l'ordre de parcours de codage prédéterminé et d'autre part par le regroupement de blocs constituant la sous-séquence courante. Le rectangle est donc choisi en fonction de l'ordre de parcours de codage prédéterminé.

On notera que le rectangle est bien adapté aux parcours de type ligne ou colonne, par exemple mais de manière non limitative au parcours de type "raster scan".

La contrainte relative au choix d'un groupe voisin codé situé dans ce rectangle permet notamment de diminuer le décalage temporel nécessaire entre le décodage de sous-séquences non-dépendantes.

En effet, , dès que toutes les sous-séquences contenues dans le rectangle sont décodées, les au moins deux sous-séquences non-dépendantes entre elles situées en frontière du rectangle peuvent être décodées simultanément.

Selon un mode de réalisation particulier de l'invention, lesdits au moins deux regroupements de blocs constituant lesdites au moins deux sous-séquences précédemment codées dudit groupe voisin codé courant sont adjacents au regroupement de blocs constituant la sous-séquence courante.

Ainsi, les deux groupes de blocs, ou super-blocs, déterminés afin d'utiliser les probabilités stockées à la fin de leur codage, sont situés dans un voisinage proche du super-bloc courant, c'est-à-dire qu'ils contiennent des blocs adjacents à au moins un bloc du super-bloc courant, de façon à permettre une meilleure adaptation locale des probabilités des symboles du super-bloc courant.

Cette caractéristique permet également de ne pas tenir compte du codage de super-blocs précédemment codés mais trop éloignés du super-bloc considéré, comme c'est le cas dans le codeur entropique « CABAC » classique lorsque l'on considère un super-bloc en début de ligne par exemple, dont le codage tient compte des blocs précédemment codés situés en fin de ligne précédente.

Selon un aspect particulier de l'invention, ladite étape d'initialisation affecte à ladite probabilité d'apparition courante une valeur égale à une combinaison des probabilités d'apparition connues associées à au moins deux sous-séquences précédemment codées dudit groupe voisin codé courant.

Ainsi, au début du codage d'une sous-séquence, ou d'un super-bloc, les probabilités des symboles sont initialisées à partir des valeurs d'au moins deux points de synchronisation précédemment obtenus, c'est-à-dire à partir des probabilités stockées lors du codage précédent d'au moins deux super-blocs. Par exemple, pour chaque symbole du super-bloc, la probabilité d'apparition du symbole est initialisée à une valeur égale à une moyenne des probabilités d'apparition de ce symbole stockées à la fin du codage précédent de deux super-blocs, situées dans le groupe voisin codé du super-bloc considéré.

L'avantage est de réutiliser judicieusement l'apprentissage du voisinage : au lieu de prendre une seule valeur par défaut ou celle d'un voisin prédéfini, on prend au moins deux valeurs voisines ce qui permet une meilleure initialisation et donc un codage plus efficace.

Selon un mode de réalisation particulier de l'invention, ladite combinaison tient compte des probabilités d'apparition connues associées à une première sous-séquence dudit groupe voisin codé courant, située à gauche de ladite sous-séquence courante et à une seconde sous-séquence dudit groupe voisin codé courant, située au-dessus de ladite sous-séquence courante.

Ainsi, pour un super-bloc donné, on tiendra compte du codage des deux super-blocs voisins situés respectivement à gauche et en haut du super-bloc donné. Ce choix des deux super-blocs constituant le groupe voisin codé d'un super-bloc est particulièrement adapté à un parcours ligne par ligne, de type « raster-scan », des super-blocs de l'image. En effet, le super-bloc situé en haut et le super-bloc situé à gauche sont déjà codés et suffisamment proches du super-bloc considéré pour que les probabilités d'apparition des symboles, stockées à la fin de leurs codages respectifs, soient pertinentes pour le codage du super-bloc considéré.

Si l'on considère un parcours ligne par ligne des super-blocs de l'image, en partant du haut de l'image, mais de droite à gauche, alors le choix des super-blocs du groupe voisin codé se porte au contraire sur les super-blocs situés respectivement à droite et en haut du super-bloc considéré.

Selon un aspect particulier de l'invention, le procédé de codage comprend également une étape de détermination d'une mesure de confiance affectée à ladite probabilité d'apparition courante après codage du dernier symbole de ladite sous-séquence courante.

Ainsi, à chaque probabilité d'apparition d'un symbole stockée à la fin du codage d'une sous-séquence est affectée une mesure de confiance, permettant de tenir compte de la « pertinence » des probabilités obtenues.

Par exemple, lorsqu'un symbole correspond, pour un super-bloc courant, à un coefficient de résidu (dans le cas d'une prédiction inter), il se peut que les super-blocs voisins ne présentent pas de symboles de ce type. La probabilité d'apparition de ce symbole dans le super-bloc courant, qui a été héritée des sous-séquences du groupe voisin codé, n'est alors pas très pertinente pour les super-blocs voisins, et est donc pondérée par une mesure de confiance assez faible.

En particulier, ladite étape d'initialisation affecte à ladite probabilité d'apparition courante une valeur égale à une moyenne des probabilités d'apparition connues associées auxdites sous-séquences dudit groupe voisin codé courant, pondérées chacune par une mesure de confiance déterminée lors de ladite étape de détermination.

Ainsi, lorsqu'une probabilité d'apparition d'un symbole, notée première probabilité, pour une sous-séquence du groupe voisin codé est affectée d'une mesure de confiance supérieure à celle de la probabilité d'apparition, notée seconde probabilité, de ce même symbole pour une autre sous-séquence du groupe voisin codé, alors la probabilité d'apparition courante de ce symbole dans la sous-séquence courante sera initialisée à une valeur tenant plus compte de la première probabilité que de la seconde probabilité.

Selon un autre aspect de l'invention, le procédé de codage comprend :

- une étape de définition d'au moins deux classes de sous-séquences de symboles ;
- une étape d'affectation d'une classe, dite classe courante, à ladite sous-séquence courante, cette dernière ayant dans son groupe voisin codé courant au moins une sous-séquence précédemment codée, notée sous-séquence de dépendance, à laquelle est affectée une classe distincte de ladite classe courante ;
- une étape de génération d'un sous-flux par classe, chaque sous-flux portant des informations représentatives du codage entropique des symboles des sous-séquences appartenant à ladite classe.

Ainsi, on peut prévoir de décoder en parallèle les différents sous-flux, tout en respectant un séquencement particulier tenant compte des sous-séquences de dépendance.

De plus, on assure un partage des connaissances entre les processus de décodage des sous-flux, permettant ainsi de limiter les pertes de performances associées en général au décodage parallèle.

Une signalisation peut être mise en œuvre lorsque des classes sont définies pour les sous-séquences. Ainsi, tous les symboles codés correspondant aux sous-séquences d'une même classe sont regroupés, dans l'ordre de codage prédéterminé. Ensuite, les classes sont mises bout à bout dans le flux, en tenant compte de leur dépendance, et sont séparées par des marqueurs de fin de classes dans le flux. Ce sont ces marqueurs qui seront donc utilisés lors du décodage, décrit ci-dessous.

Un autre aspect de l'invention concerne un procédé de décodage d'un flux représentatif d'au moins une image codée, procédé de décodage défini par la revendication 10.

Ainsi, l'invention repose sur une approche nouvelle et inventive du décodage d'image, et plus particulièrement du décodage entropique, permettant à la fois un apprentissage plus efficace des probabilités d'apparition des symboles pour le codage et un décodage en parallèle des symboles codés.

Ce procédé de décodage pourra bien sûr comporter les différentes caractéristiques relatives au procédé de codage selon l'invention.

En particulier, une classe étant affectée à au moins une sous-séquence de symboles lors dudit codage, ledit flux est formé d'au moins deux sous-flux associés chacun à une desdites classes, chaque sous-flux portant des informations représentatives du codage entropique des symboles des sous-séquences appartenant à ladite classe, et lesdites étapes d'initialisation, de décodage et de stockage pour des sous-séquences appartenant à une même classe sont mises en œuvre sous-flux par sous-flux, lesdits sous-flux étant traités en parallèle, lesdites étapes d'initialisation, de décodage et de stockage pour au moins une sous-séquence de dépendance ayant été préalablement mises en œuvre.

Ainsi, l'invention, selon un mode de réalisation, permet le décodage en parallèle de certaines sous-séquences, par la mise en œuvre en parallèle des différentes étapes de décodage décrites ci-dessus.

En particulier, lorsque des classes ont été affectées aux différentes sous-séquences lors du codage et lorsque le flux a été formé de telle façon qu'il comprend des sous-flux correspondants aux classes, alors le procédé de décodage peut tenir compte de ces classes pour décoder les différentes sous-séquences en parallèle. Ainsi, les différentes classes permettent de définir un certain séquencement pour le décodage, c'est-à-dire des contraintes d'ordonnancement des sous-séquences à décoder.

Par exemple, les sous-séquences de dépendance affectées d'une classe différente de la classe affectée à la sous-séquence courante doivent avoir été décodées préalablement au décodage de la sous-séquence courante.

En revanche, toutes les sous-séquences « indépendantes » entre elles, c'est-à-dire n'apparaissant pas dans le groupe voisin décodé d'une autre, et n'ayant pas de sous-séquences de dépendance non encore décodées, peuvent être décodées en parallèle.

Un autre aspect de l'invention concerne un dispositif de codage d'au moins une image représentée par une séquence de symboles générée selon un ordre de parcours de codage prédéterminé.

Selon l'invention, un tel dispositif de codage est défini par la revendication 12.

Un tel dispositif de codage est notamment adapté à mettre en œuvre le procédé de codage décrit précédemment. Il s'agit par exemple d'un codeur vidéo de type MPEG ou H.264, ou selon une future norme de compression.

Ce dispositif de codage pourra bien sûr comporter les différentes caractéristiques relatives au procédé de codage selon l'invention.

Encore un autre aspect de l'invention concerne un dispositif de décodage d'un flux représentatif d'au moins une image codée.

Selon l'invention, un tel dispositif de décodage est défini par la revendication 13.

Un tel dispositif de décodage est notamment adapté à mettre en œuvre le procédé de décodage décrit précédemment. Il s'agit par exemple d'un décodeur vidéo de type MPEG ou H.264, ou selon une future norme de compression vidéo.

Ce dispositif de décodage pourra bien sûr comporter les différentes caractéristiques relatives au procédé de décodage selon l'invention.

Un autre aspect de l'invention concerne un programme d'ordinateur comportant des instructions pour la mise en œuvre du procédé de codage ou de décodage tel que décrit ci-dessus, lorsque ledit programme est exécuté par un processeur.

On note en effet que le procédé de codage, ou le procédé de décodage, selon l'invention peuvent être mis en œuvre de diverses manières, notamment sous forme câblée ou sous forme logicielle.

Un autre aspect de l'invention concerne également un dispositif de transcodage.

Selon l'invention, un tel dispositif de transcodage est défini par la revendication 15.

Le décodage entropique est donc suivi d'une étape de ré-encodage entropique des symboles. Le ré-encodage est alors similaire au codage tel que décrit dans l'invention.

Un tel transcodeur permet de définir de nouvelles sous-séquences à partir d'une séquence de symboles codés, en fonction des capacités du terminal qui devra effectuer le décodage. En particulier le transcodeur peut adapter la complexité de décodage aux capacités du terminal. Par exemple, le transcodeur définit quatre ou huit ou N classes de décodage selon les capacités du terminal de décodage (par exemple, le nombre de processeurs qui peuvent fonctionner en parallèle).

**4. Liste des figures**

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :

- la figure 1, déjà commentée en relation avec l'art antérieur, présente un exemple de parcours des blocs d'une image de type « raster-scan » ;
- la figure 2a présente les principales étapes du procédé de codage, selon un mode de réalisation de l'invention ;
- la figure 2b présente d'autres étapes du procédé de codage, selon ce mode de réalisation de l'invention ;
- la figure 3 présente un exemple de partitionnement de l'image selon un mode de réalisation de l'invention ;
- la figure 4a présente les principales étapes du procédé de décodage, selon un mode de réalisation de l'invention ;
- la figure 4b présente d'autres étapes du procédé de décodage, selon ce mode de réalisation de l'invention ;
- les figures 5a, 5b et 5c présentent des exemples d'ordre de codage/décodage possible selon un mode de réalisation de l'invention ;
- les figures 6 et 7 présentent respectivement la structure d'un dispositif de codage et d'un dispositif de décodage, selon un mode de réalisation particulier de l'invention ;
- la figure 8 présente la structure d'un dispositif de transcodage selon un mode de réalisation de l'invention.

**5. Description d'un mode de réalisation de l'invention**

*5.1 Principe général*

Le principe général de l'invention repose sur un apprentissage « multidimensionnel » des probabilités d'apparition des symboles, non dépendant de l'ordre de parcours de l'image, et permettant une adaptation locale des probabilités d'apparition des symboles et un décodage non séquentiel des symboles codés.

Ainsi, selon l'invention, l'apprentissage des probabilités d'apparition des symboles est basé sur un partitionnement de l'image en sous-séquences de symboles, pour lesquelles les probabilités d'apparition des symboles sont stockées en fin de codage et utilisées pour l'initialisation des probabilités d'apparition des symboles dans un voisinage proche, quelque soit l'ordre de parcours de l'image pour le codage.

*5.2 Description de modes de réalisation du codage*

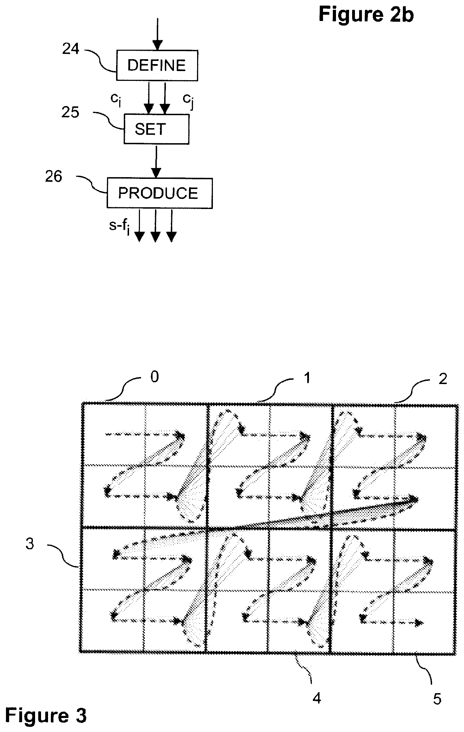

On décrit maintenant, en relation avec la figure 2, les principales étapes du procédé de codage selon un mode de réalisation de l'invention.

Lors d'une étape 21 de génération, une séquence de symboles correspondant à l'image à coder est générée, selon un ordre de parcours prédéterminé.

Cette étape de génération 21 peut être mise en œuvre au fil de l'eau, c'est-à-dire que les étapes suivantes 22, et 231 à 234, peuvent être mises en œuvre en parallèle avec cette étape 21.

A partir de cette séquence de symboles, des sous-séquences de symboles sont déterminées, lors d'une étape 22 de détermination, correspondant chacune à un regroupement prédéterminé de symboles.

Ce regroupement peut correspondre par exemple à un regroupement de blocs de l'image, noté super-bloc. Dans la suite de la description, on considère un regroupement de blocs comprenant un nombre fixe de blocs de taille fixe. On notera toutefois que l'invention n'est pas limitée à cet exemple et pourrait tout aussi bien s'appliquer à des regroupements de blocs comprenant un nombre variable de blocs de taille variable.

Une fois ces sous-séquences déterminées, elles sont parcourues lors d'une étape 23 de parcours, comprenant, pour une sous-séquence courante, et pour un contexte, les étapes 231 à 234 décrites ci-dessous.

On considère à nouveau dans ce mode de réalisation un seul contexte pour la sous-séquence courante, mais le procédé de codage selon l'invention peut être mis en œuvre pour plusieurs contextes.

La première étape 231 consiste à déterminer, pour la sous-séquence courante, un groupe voisin codé courant

comprenant au moins deux sous-séquences précédemment codées. De plus, parmi ces sous-séquences précédemment codées et choisies pour appartenir au groupe voisin codé courant, au moins une appartient à un autre groupe voisin codé associé à une autre sous-séquence distincte de la sous-séquence courante considérée et non encore codée.

Lors d'une deuxième étape d'initialisation 232, on initialise, pour la sous-séquence courante, la ou les probabilités d'apparition, notée(s) probabilité(s) d'apparition courante, d'un symbole associé au contexte. Chaque probabilité d'apparition courante tient compte d'au moins deux probabilités d'apparition connues du symbole, c'est-à-dire obtenues lors du précédent codage d'au moins deux sous-séquences appartenant au groupe voisin codé courant déterminé à l'étape 231.

L'étape suivante 233 de codage consiste à effectuer un codage entropique successif des symboles de la sous-séquence, selon l'ordre de parcours prédéterminé utilisé lors de l'étape 21, et à mettre à jour la ou les probabilités d'apparition associées à chaque symbole.

Enfin, une fois tous les symboles de la sous-séquence ainsi codés, la ou les probabilités d'apparition sont stockées, lors d'une étape 234 de stockage, en vue de leur utilisation pour le codage d'autres sous-séquences voisines, lors des itérations suivantes de l'étape 23.

On notera que le codage peut être fait au fil de l'eau, c'est-à-dire que les étapes décrites ci-dessus peuvent se dérouler en parallèle.

La figure 3 illustre un exemple de parcours de l'image pour un codage entropique selon ce mode de réalisation de l'invention, dans lequel une sous-séquence correspond à un super-bloc comprenant quatre blocs.

La figure 3 montre six super-blocs, numérotés de 0 à 5 selon un ordre de parcours des super-blocs ligne par ligne de type « raster-scan ».

Lors du codage d'un super-bloc, les probabilités d'apparition associées au super-bloc situé à gauche ainsi que celles associées au super-bloc situé au dessus sont donc disponibles. On considère donc que ces deux super-blocs constituent le groupe voisin codé courant pour un super bloc courant considéré.

Par exemple, si l'on considère le super-bloc 4 de la figure 3 comme le super-bloc courant, les super-blocs 1 et 3 constituent le groupe voisin codé courant. On remarque que le super-bloc 1 peut également faire partie d'un groupe voisin codé pour le super-bloc 2.

Si l'on considère un ordre de parcours des super-blocs différent d'un parcours de type « raster-scan », par exemple un parcours ligne par ligne de droite à gauche, en partant du haut de l'image à droite. On peut alors choisir, pour le super-bloc courant 4, un groupe voisin codé comprenant les super-blocs 1 et 5.

En généralisant, pour un super-bloc courant $(i,j)$ (c'est-à-dire le $j$-ème super-bloc situé sur la $i$-ème ligne de super-blocs), l'étape d'initialisation définit la valeur de la probabilité d'apparition d'initialisation $P_{SB,init}(i,j)$ de la manière suivante :

$P_{SB,init}(i,j) = \text{Averaging}(P_{SB,stockée}(i, j-1) ; P_{SB,stockée}(i-1; j))$, avec $P_{SB,stockée}(i, j-1)$ et $P_{SB,stockée}(i-1; j)$ respectivement les valeurs des probabilités d'apparition stockées à la fin du codage des super-blocs $(i, j-1)$ et $(i-1; j)$.

La probabilité d'apparition d'initialisation $P_{SB,init}(i,j)$ correspond à une combinaison obtenue à partir des probabilités stockées $P_{SB,stockée}$ pour les super-blocs du groupe voisin codé courant.

Selon une première variante, $P_{SB,init}(i,j)$ est égale à la moyenne de ces deux probabilités, soit : $P_{SB,init}(i,j) = (P_{SB,stockée}(i, j-1) + P_{SB,stockée}(i, j-1))/2$.

Selon une autre variante, on affecte à chaque probabilité d'apparition stockée une mesure de confiance, notée $N_{SB,post}( . ; . )$. On peut alors initialiser $P_{SB,init}(i,j)$ avec une valeur égale à une moyenne des deux probabilités stockées à la fin du codage des super-blocs $(i, j-1)$ et $(i-1; j)$, pondérées chacune par une mesure de confiance, soit :

$$P_{SB,init}(i,j) = ( N_{SB,stockée}(i, j-1).P_{SB,stockée}(i, j-1) + N_{SB,stockée}(i-1, j).P_{SB,stockée}(i-1; j) )/ (N_{SB,stockée}(i, j-1) + N_{SB,stockée}(i-1, j)) .$$

Dans le cas où le super-bloc de gauche n'est pas présent, on utilise alors directement les valeurs du super-bloc au dessus, et dans le cas où le super-bloc du dessus n'est pas disponible, on utilise alors directement les valeurs du super-bloc à gauche.

Dans le cas où il n'y a pas de super-bloc ni à gauche, ni au-dessus, on initialise alors à une valeur par défaut, par exemple la valeur de probabilité d'initialisation classiquement utilisée par un codeur « CABAC ».

Selon une variante de réalisation, on peut également définir une mesure de confiance $N_{SB,init}$ pour la probabilité obtenue. Cette mesure de confiance est établie par une méthode de combinaison similaire à celle décrite ci-dessus pour $P_{SB,init}$, à partir de valeurs $N_{SB,post}$ pour des super-blocs du groupe voisin codé.

On présente en Annexe A, faisant partie intégrante de la présente description, une implémentation à moindre complexité du calcul de la moyenne pondérée pour l'initialisation d'une probabilité d'apparition d'un symbole.

Une fois la probabilité d'apparition du symbole initialisée, on parcourt alors les blocs du super-bloc courant, par exemple selon un ordre de type « raster-scan », comme illustré en figure 3.

La probabilité p de codage est initialisée à la valeur $P_{SB,init}(i,j)$ préalablement définie, et évolue de façon classique par la formule :

$$p(b=0) = \alpha.p(b=0) + \begin{cases} (1-\alpha) & \text{si le bit codé est 0} \\ 0 & \text{sinon} \end{cases}$$

A l'issue du codage de tous les blocs d'un super-bloc, l'état de la valeur de probabilité d'apparition est alors stockée dans $P_{SB,stockée(i,j)}$.

Comme déjà indiquée précédemment, une mesure de confiance peut être affectée à cette probabilité, par exemple de la manière suivante :

$$N_{SB,stockée}(i,j) = \alpha'.N_{SB,init}(i,j) + (1-\alpha').N_{SB}(i,j),$$

où $\alpha'$ correspond à un facteur d'atténuation de mise à jour, ou un paramètre de contrôle de la vitesse d'apprentissage, similaire au $\alpha$ utilisé pour la mise à jour des probabilité d'un codeur arithmétique classique de type « CABAC $(\alpha = \sqrt[63]{\frac{0.01875}{0.5}} \approx 0.95)$ et $N_{SB}$ correspond au nombre de symboles codés pour le super-bloc considéré.

On présente maintenant, en relation avec la figure 2b, d'autres étapes du procédé de codage selon ce mode de réalisation de l'invention, permettant notamment un décodage en parallèle de certaines sous-séquences.

Ainsi, selon ce mode de réalisation de l'invention, le procédé de codage considère des classes associées à des sous-séquences, rendant possible le codage/décodage en parallèle dans plusieurs processus, en respectant des contraintes d'ordonnancement sur les traitements des différents super-blocs au sein de ces processus.

Dans un premier temps, lors d'une étape 24 de définition, on définit aux moins deux classes $c_i$ et $c_j$ de sous-séquences, pour les sous-séquences définies préalablement lors de l'étape 22.

Ensuite, lors d'une étape 25 d'affectation, on affecte une classe à la sous-séquence courante, sachant que cette dernière a dans son groupe voisin codé courant au moins une sous-séquence précédemment codée, notée sous-séquence de dépendance, à laquelle est affectée une classe distincte de ladite classe courante.

Ainsi, on marque ici, au codage, une dépendance entre certaines sous-séquences, par l'affectation d'une classe, qui sera utilisée lors du décodage.

Enfin, on génère un sous-flux $s-f_i$ par classe, lors d'une étape 26 de génération, chaque sous-flux portant des informations représentatives du codage entropique des symboles des sous-séquences appartenant à ladite classe.

De cette manière, les sous-séquences ne présentant pas de dépendance peuvent être décodées en parallèle, et le décodage des sous-séquences présentant une dépendance doit être effectuée en respectant cette contrainte de dépendance.

En particulier, les sous-flux peuvent être générés par un transcodeur, qui permet, à partir d'un flux binaire représentant une séquence de symboles codés pour une image, de générer plusieurs sous-flux binaires décodables de manière parallèle tel que décrit dans l'invention.

La séquence de symboles codés originale peut ou non contenir des sous-séquences décodables en parallèle, c'est-à-dire qu'elle peut avoir été générée à partir d'un codeur tel que celui de l'invention ou bien par un codeur classique.

Un but du transcodeur est de définir de nouvelles sous-séquences, en fonction des capacités du terminal qui devra effectuer le décodage. Ceci permet donc d'adapter la complexité de décodage aux capacités du terminal. Par exemple, le transcodeur pourra ainsi définir quatre, huit, ou x classes de décodage selon les capacités du terminal de décodage.

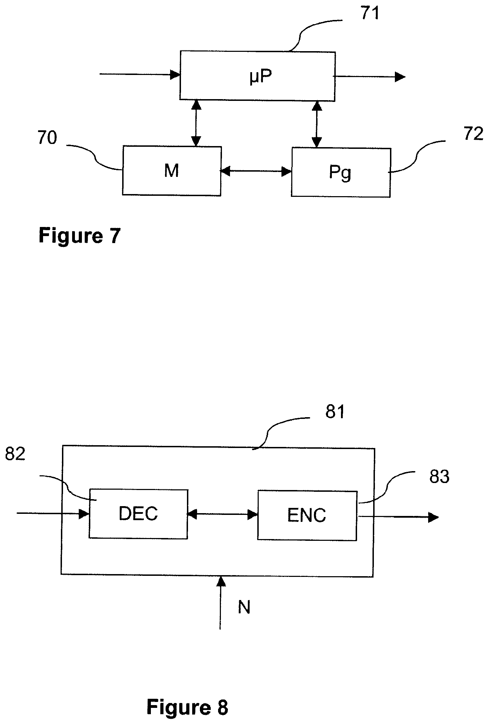

Un exemple de dispositif de transcodage 81 selon l'invention est maintenant décrit en référence à la figure 8. Il comprend un dispositif de décodage entropique 82 et un dispositif de codage 83 selon l'invention. Sur réception d'une première séquence de symboles codés représentative d'une ou plusieurs images, le dispositif de décodage entropique fournit une séquence de symboles décodés, qui est transmise au dispositif de codage selon l'invention pour ré-encodage en une deuxième séquence de symboles codées. Le décodage entropique est similaire à celui de l'invention si la séquence originale contient des sous-séquences ou à un décodage classique si la séquence originale n'est contient pas. Le ré-encodage entropique est lui similaire au codage tel que décrit dans l'invention.

Selon un aspect de l'invention, le dispositif de transcodage 81 est apte à définir des classes en fonction de connaissances a priori, relatives aux capacités d'un terminal destinataire de la deuxième séquence de symboles codés, par exemple en termes de nombre de processeurs disponibles. Dans ce cas, le dispositif de transcodage selon l'invention fournit autant de sous-flux binaires que de classes précédemment définies.

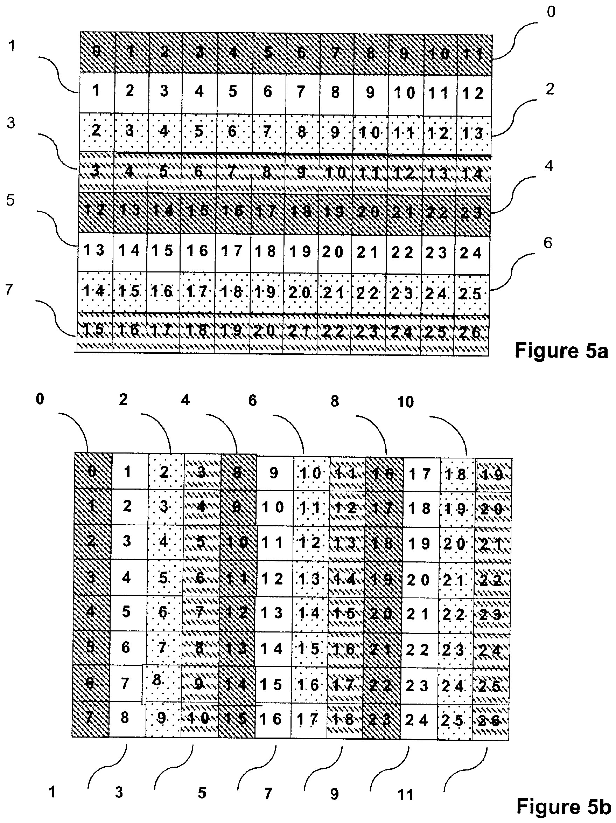

Les figures 5a à 5c illustrent trois exemples d'affectation de classes à des sous-séquences, dans le cas où une sous-séquence correspond à un super-bloc (un super-bloc est représenté par un carré numéroté).

Elles seront décrites plus en détails ci-dessous.

*5.3 Description de modes de réalisation du décodage*

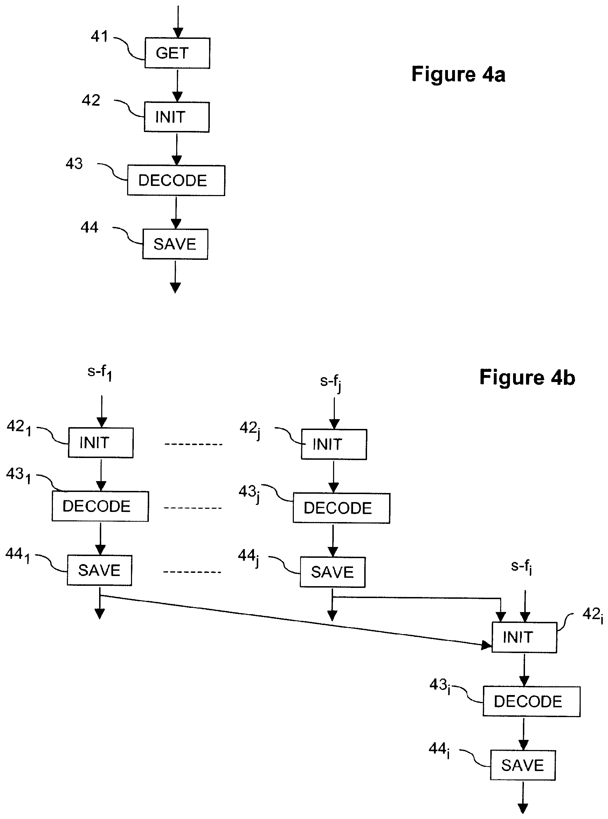

On présente donc maintenant, en relation avec les figures 4a et 4b, le procédé de décodage selon des modes de réalisation de l'invention.

Lors d'une première étape 41, on obtient une sous-séquence comprenant un regroupement prédéterminé de symboles à décoder, noté sous-séquence courante.

Ensuite, lors d'une étape d'initialisation 42, on initialise la ou les probabilités d'apparition, notée(s) probabilité(s) d'apparition courante, d'un symbole de la sous-séquence associé au contexte. Chaque probabilité d'apparition courante tient compte d'au moins deux probabilités d'apparition connues du symbole, c'est-à-dire obtenues lors du précédent décodage d'au moins deux sous-séquences appartenant à un voisinage de la sous-séquence courante.

Ce voisinage est appelé groupe voisin décodé courant et comprend au moins deux sous-séquences précédemment décodées, parmi lesquelles au moins une appartient à un groupe voisin décodé associé à une sous-séquence distincte de la sous-séquence courante. Ainsi, une sous-séquence peut servir au décodage de plusieurs autres sous-séquences.

L'étape suivante 43 de décodage consiste à effectuer un décodage entropique successif des symboles de la sous-séquence, selon un ordre de parcours mis en œuvre lors d'un codage de l'image, et à mettre à jour la ou les probabilités d'apparition associées à chaque symbole.

Enfin, une fois tous les symboles de la sous-séquence ainsi décodés, la ou les probabilités d'apparition sont stockées, lors d'une étape 44 de stockage, en vue de leur utilisation pour le décodage d'autres sous-séquences voisines, lors des itérations des étapes 42 à 44.

On décrit maintenant, en relation avec les figures 4b et 5a à 5c, d'autres étapes du procédé de décodage, selon ce mode de réalisation de l'invention.

La figure 4b présente un exemple de décodage en parallèle selon un mode de réalisation de l'invention.

Selon ce mode de réalisation, une classe a été affectée à au moins une sous-séquence de symboles lors du codage et le flux à décoder est formé d'au moins deux sous-flux associés chacun à une classe. Chaque sous-flux porte des informations représentatives du codage entropique des symboles des sous-séquences appartenant à la classe, codage effectué selon le procédé de codage de l'invention décrit précédemment.

Les étapes 42, 43 et 44 décrites ci-dessus peuvent alors être mises en œuvre sous-flux par sous-flux.

Comme illustré sur la figure 4b, les sous-flux $s$-$f_l$ à $s$-$f_j$ peuvent ainsi être traités en parallèle, dès lors que les sous-séquences de dépendances, telles que décrit précédemment, ont déjà été décodées.

La figure 4b illustre également un exemple de dépendance entre plusieurs sous-flux. Ainsi, le sous-flux $s$-$f_i$ est traité seulement une fois que le traitement des deux sous-flux $s$-$f_l$ et $s$-$f_j$ est terminé, car l'étape d'initialisation $42_i$ tient compte des probabilités stockées respectivement aux étapes $44_l$ et $44_j$. C'est le cas lorsque la sous-séquence correspondant au sous-flux $s$-$f_i$ a un groupe voisin décodé courant comprenant les deux sous-séquences correspondant aux deux sous-flux $-f_l$ et $s$-$f_j$.

Les figures 5a à 5c illustrent particulièrement trois exemples d'ordre de décodage possible des sous-séquences, correspondant à des super-blocs dans ce mode de réalisation.

La figure 5a illustre un exemple de réalisation dans lequel la même classe est affectée à toutes les sous-séquences d'une même ligne de l'image, par exemple la classe numérotée 0 correspond à la première ligne en haut de l'image, la classe 1 à la deuxième ligne, etc.

Ainsi, les super-blocs numérotés de 0 à 11 sur la ligne 0 sont tous affectés de la même classe 0, et forment un sous-flux 0, de même pour tous les super-blocs de la ligne 4. Selon ce mode de réalisation, on considère qu'un super-bloc, pour être décodé, utilise les probabilités stockées lors du décodage de deux deux super-blocs voisins, ceux situés respectivement au-dessus et à gauche. Ainsi, les super-blocs de la ligne 0 doivent être décodés séquentiellement, le bloc situé à gauche devant être décodé préalablement au décodage du bloc courant.

En revanche, si l'on considère la ligne 1, on peut voir qu'à partir du moment où les blocs 0 et 1 de la ligne 0 sont décodés, les blocs de la ligne 1 peuvent être décodés également. En effet, le bloc 2 de la ligne 1 a besoin des blocs 1 des lignes 0 et 1 décodés, et ainsi de suite.

Selon ce mode de réalisation, les différentes lignes peuvent donc être décodées en parallèle, en respectant la contrainte de dépendance, c'est-à-dire en commençant le décodage de la ligne 0 avant le décodage de la ligne 1, et ainsi de suite.

D'un point de vue temporel, si l'on considère que les numéros des blocs correspondent à l'instant auquel ils sont décodés, on peut donc voir qu'à l'instant t=4 par exemple, les blocs 4 des lignes 0, 1, 2 et 3 peuvent être décodés.

Sur la figure 5b, une classe est affectée aux super-blocs d'une même colonne, et un sous-flux correspond donc à une colonne. Le principe est le même que celui décrit en relation avec la figure 5a, avec des colonnes.

Ces deux exemples de réalisation montrent que les quatre-vingt-seize super-blocs de l'image peuvent être décodés en vingt-sept instants, au lieu de quatre-vingt-seize instants pour un décodage classique.

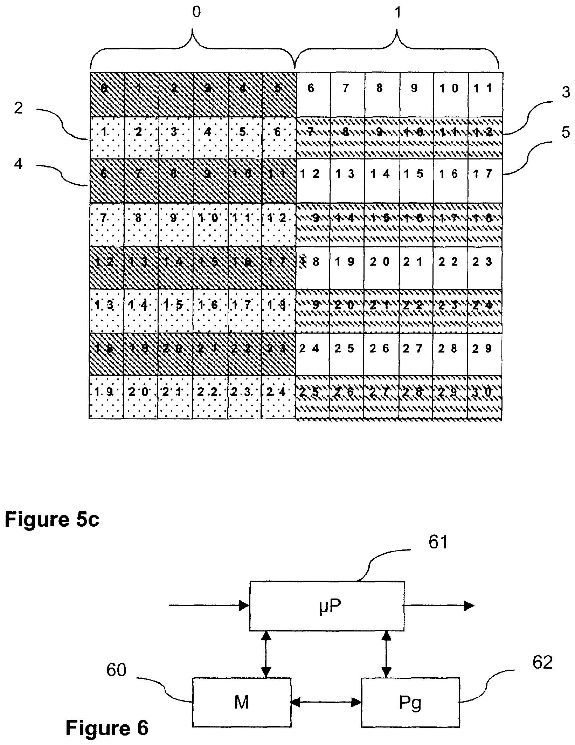

Sur la figure 5c, une classe est affectée à une demie ligne et permet de décoder les quatre-vingt-seize blocs de l'image en trente et un instants.

*5.4 Structure des dispositifs de codage et de décodage*

On présente finalement, en relation avec les figures 6 et 7, la structure simplifiée d'un dispositif de codage et d'un dispositif de décodage selon les modes de réalisation décrits ci-dessus.

Comme illustré en figure 6, un tel dispositif de codage comprend une mémoire 60 comprenant une mémoire tampon, une unité de traitement 62, équipée par exemple d'un microprocesseur $\mu$P, et pilotée par le programme d'ordinateur 63, mettant en œuvre le procédé de codage selon l'invention.

A l'initialisation, les instructions de code du programme d'ordinateur 63 sont par exemple chargées dans une mémoire RAM avant d'être exécutées par le processeur de l'unité de traitement 62. L'unité de traitement 62 reçoit en entrée une image, représentée par une sous-séquence de symboles. Le microprocesseur de l'unité de traitement 62 met en œuvre les étapes du procédé de codage décrit précédemment, selon les instructions du programme d'ordinateur 63. Pour cela, le dispositif de codage comprend, outre la mémoire tampon 60, des moyens de détermination de sous-séquences dans ladite séquence, une sous-séquence comprenant un regroupement prédéterminé de symboles, des moyens de parcours des sous-séquences déterminées, comprenant, pour au moins une sous-séquence courante et pour au moins un contexte, des moyens de détermination d'un groupe voisin comprenant au moins deux sous-séquences précédemment codées, dit groupe voisin codé courant, parmi lesquelles au moins une appartient à un groupe voisin codé associé à une sous-séquence distincte de ladite sous-séquence courante, ladite sous-séquence distincte n'appartenant pas audit groupe voisin codé de la sous-séquence courante et ladite sous-séquence courante n'appartenant pas au groupe voisin codé de ladite sous-séquence distincte, des moyens d'initialisation d'au moins une probabilité d'apparition d'un symbole associé audit contexte, dite probabilité d'apparition courante, tenant compte d'au moins deux probabilités d'apparition dudit symbole, dites probabilités d'apparition connues, relatives à deux sous-séquences précédemment codées dudit groupe voisin codé courant, des moyens de codage entropique successif desdits symboles selon ledit ordre de parcours de codage prédéterminé, et pour chaque symbole, des moyens de mise à jour de ladite probabilité d'apparition courante pour le contexte associé audit symbole, et des moyens de stockage de ladite probabilité d'apparition courante desdits symboles codés dans la sous-séquence courante, après codage du dernier symbole de ladite sous-séquence courante. Ces moyens sont pilotés par le microprocesseur de l'unité de traitement 62. L'unité de traitement 62 transmet donc, à destination d'au moins un dispositif de décodage, un flux représentatif d'au moins une image codée.

Comme illustré en figure 7, un tel dispositif de décodage comprend quant à lui une mémoire 70 comprenant une mémoire tampon, une unité de traitement 72, équipée par exemple d'un microprocesseur $\mu$P, et pilotée par le programme d'ordinateur 73, mettant en œuvre le procédé de décodage selon l'invention.

A l'initialisation, les instructions de code du programme d'ordinateur 73 sont par exemple chargées dans une mémoire RAM avant d'être exécutées par le processeur de l'unité de traitement 72. L'unité de traitement 72 reçoit en entrée un flux représentatif d'au moins une image codée. Le microprocesseur de l'unité de traitement 72 met en œuvre les étapes du procédé de décodage décrit précédemment, selon les instructions du programme d'ordinateur 73. Pour cela, le dispositif de décodage comprend, outre la mémoire tampon 70, des moyens d'obtention d'au moins une sous-séquence comprenant un regroupement prédéterminé de symboles, et, pour au moins une sous-séquence ainsi obtenue et pour au moins un contexte, des moyens d'initialisation d'au moins une probabilité d'apparition d'un symbole associé audit contexte, dite probabilité d'apparition courante, tenant compte d'au moins deux probabilités d'apparition dudit symbole, dites probabilités d'apparition connues, relatives à deux sous-séquences précédemment décodées d'un groupe voisin décodé courant, un groupe voisin décodé comprenant au moins deux sous-séquences précédemment décodées, parmi lesquelles au moins une appartient à un groupe voisin décodé associé à une sous-séquence distincte de ladite sous-séquence courante, des moyens de décodage entropique successif desdits symboles selon un ordre de parcours de codage mis en œuvre lors d'un codage de ladite image, et pour chaque symbole, des moyens de mise à jour de ladite probabilité d'apparition courante pour le contexte associé audit symbole, et des moyens de stockage de ladite probabilité d'apparition courante desdits symboles décodés dans la sous-séquence courante, après décodage du dernier symbole de ladite sous-séquence courante. Ces moyens sont pilotés par le microprocesseur de l'unité de traitement 72.

**ANNEXE A**

Si ($N_{SB,stockée}(i, j-1) > 0$)

alors W0 = $\log_2(N_{SB,stockée}(i, j-1))$; // tabulation possible
sinon W0 = Tmin;
Si (W0 > Tmax) alors W0=Tmax
Si ($N_{SB,stockée}(i-1,j)>0$)
alors W1 = log2($N_{SB,stockée}(i-1, j)$)); // tabulation possible
sinon W1 = Tmin;
Si (W1 > Tmax) alors W1=Tmax;
K = W0-W1;
Si (K>0) alors
Si (K>16) alors K=16;
$P_{SB,init}$ = $P_{SB,stockée}(i, j-1)$;
$P_{SB,init}$+= ($P_{SB,stockée}(i-1, j)$ - $P_{SB,stockée}(i, j-1)$ + (1<<(K-1)) ) >> K;
// même formule pour $N_{SB,init}$ avec le facteur K
Sinon
K=-K;
Si (K>16) alors K=16;
PSB,init = PSB,stockée(i-1, j);
PSB,init += (PSB,stockée(i, j-1) - PSB,stockée(i-1,j) + (1<<(K-1)) ) >> K;
// même formule pour $N_{SB,init}$ avec le facteur K
Fin
Des valeurs typiques des paramètres pour des super-blocs de taille 8x8 blocs (blocs de taille 8x8) sont: Tmin=-20, Tmax=14.

## Revendications

1. Procédé de codage d'au moins une image représentée par une séquence de symboles générée (21) selon un ordre de parcours de codage prédéterminé, **caractérisé en ce qu'**il comprend les étapes suivantes :

   - détermination (22) de sous-séquences dans ladite séquence de symboles, une sous-séquence correspondant à un regroupement prédéterminé de symboles ;
   - les sous-étapes suivantes étant réalisées pour chaque sous-séquence déterminée, dite sous-séquence courante, :

      - Détermination(231) d'un groupe voisin, dit groupe voisin codé courant, comprenant au moins deux sous-séquences précédemment codées, parmi lesquelles au moins une sous-séquence du groupe voisin codé courant appartient à un groupe voisin codé déterminé pour une sous-séquence distincte de ladite sous-séquence courante, ladite sous-séquence distincte n'appartenant pas audit groupe voisin codé courant déterminé pour la sous-séquence courante et ladite sous-séquence courante n'appartenant pas au groupe voisin codé déterminé pour ladite sous-séquence distincte ;
      - ladite sous-séquence distincte et la sous-séquence courante étant aptes à être décodées en parallèle,
      - initialisation (232), pour chaque contexte associé à un symbole de ladite séquence de symboles à coder, d'une probabilité d'apparition dudit symbole associé audit contexte, dite probabilité d'apparition courante, en tenant compte d'au moins deux probabilités d'apparition dudit symbole, dites probabilités d'apparition connues, lesdites probabilités d'apparition connues ayant été stockées respectivement à la fin du codage entropique desdites au moins deux sous-séquences précédemment codées dudit groupe voisin codé courant ;
      - codage (233) entropique successif desdits symboles de la sous-séquence courante selon ledit même ordre de parcours de codage prédéterminé utilisé pour générer la séquence de symboles, et pour chaque symbole codé, mise à jour de ladite probabilité d'apparition courante pour le contexte associé audit symbole ;
      - stockage (234), pour chaque contexte associé à un symbole de ladite séquence de symbole codée, de ladite probabilité d'apparition courante associée audit contexte, après codage du dernier symbole de ladite sous-séquence courante.

2. Procédé de codage selon la revendication 1, dans lequel l'étape de génération d'une séquence de symboles est obtenue à l'aide d'un codage par blocs, ledit procédé étant **caractérisé en ce que** le regroupement prédéterminé de symboles correspond à un regroupement de blocs de taille fixe.

**3.** Procédé de codage selon la revendication 2, **caractérisé en ce que** ledit groupe voisin codé courant est situé dans un rectangle délimité d'une part par le premier bloc codé de l'image selon l'ordre de parcours de codage prédéterminé et d'autre part par le regroupement de blocs constituant la sous-séquence courante.

**4.** Procédé de codage selon la revendication 3, **caractérisé en ce que** lesdits au moins deux regroupements de blocs constituant lesdites au moins deux sous-séquences précédemment codées dudit groupe voisin codé courant sont adjacents au regroupement de blocs constituant la sous-séquence courante.

**5.** Procédé de codage selon la revendication 1, **caractérisé en ce que** ladite étape d'initialisation affecte à ladite probabilité d'apparition courante une valeur égale à une combinaison des probabilités d'apparition connues associées à au moins deux sous-séquences précédemment codées dudit groupe voisin codé courant.

**6.** Procédé de codage selon la revendication 5, **caractérisé en ce que**, lorsque l'étape de génération d'une séquence de symboles est obtenue à l'aide d'un codage par blocs, et que le regroupement prédéterminé de symboles correspond à un regroupement de blocs de taille fixe, ladite combinaison tient compte des probabilités d'apparition connues associées à une première sous-séquence dudit groupe voisin codé courant, située à gauche de ladite sous-séquence courante et à une seconde sous-séquence dudit groupe voisin codé courant, située au-dessus de ladite sous-séquence courante.

**7.** Procédé de codage selon la revendication 1, **caractérisé en ce qu'**il comprend également une étape de détermination d'une mesure de confiance affectée à ladite probabilité d'apparition courante après codage du dernier symbole de ladite sous-séquence courante.

**8.** Procédé de codage selon la revendication 7, **caractérisé en ce que** ladite étape d'initialisation affecte à ladite probabilité d'apparition courante une valeur égale à une moyenne des probabilités d'apparition connues associées auxdites sous-séquences dudit groupe voisin codé courant, pondérées chacune par une mesure de confiance déterminée lors de ladite étape de détermination.

**9.** Procédé de codage selon la revendication 1, **caractérisé en ce qu'**il comprend :

- une étape de définition d'au moins deux classes de sous-séquences de symboles ;
- une étape d'affectation d'une classe, dite classe courante, à ladite sous-séquence courante, ladite sous-séquence courante ayant dans son groupe voisin codé courant au moins une sous-séquence précédemment codée, notée sous-séquence de dépendance, à laquelle est affectée une classe distincte de ladite classe courante ;
- une étape de génération d'un sous-flux par classe, chaque sous-flux portant des informations représentatives du codage entropique des symboles des sous-séquences appartenant à ladite classe.

**10.** Procédé de décodage d'un flux représentatif d'au moins une image codée, **caractérisé en ce qu'**il comprend les étapes suivantes :

- obtention (41) à partir dudit flux, d'au moins une sous-séquence, dite sous-séquence courante, ladite sous-séquence correspondant à un regroupement prédéterminé de symboles codés ; et, pour ladite au moins une sous-séquence courante et pour chaque contexte associé à un symbole de la sous-séquence courante à décoder:

- initialisation (42) d'une probabilité d'apparition dudit symbole associé audit contexte, dite probabilité d'apparition courante, en tenant compte d'au moins deux probabilités d'apparition dudit symbole, dites probabilités d'apparition connues, lesdits probabilités d'apparition connues ayant été stockées respectivement à la fin du décodage entropique d'au moins deux sous-séquences précédemment décodées d'un groupe voisin décodé déterminé pour la sous-séquence courante, un groupe voisin décodé comprenant lesdites au moins deux sous-séquences précédemment décodées, parmi lesquelles au moins une sous-séquence précédemment décodée appartient à un groupe voisin décodé déterminé pour une sous-séquence distincte de ladite sous-séquence courante, ladite sous-séquence distincte n'appartenant pas audit groupe voisin codé courant déterminé pour la sous-séquence courante et ladite sous-séquence courante n'appartenant pas au groupe voisin codé déterminé pour ladite sous-séquence distincte;
- ladite sous-séquence distincte et la sous-séquence courante étant aptes à être décodées en parallèle,
- décodage entropique successif (43) desdits symboles de la sous-séquence courante selon un même ordre de parcours de codage mis en œuvre lors d'une génération desdits symboles lors du codage de ladite image, et pour chaque symbole, mise à jour de ladite probabilité d'apparition courante pour le contexte associé audit symbole décodé ;
- stockage (44), pour chaque contexte associé à un symbole de ladite séquence de symbole codée, de ladite probabilité d'apparition courante associée audit contexte de la sous-séquence courante, après décodage du dernier symbole de ladite sous-séquence courante.

11. Procédé de décodage selon la revendication 10, **caractérisé en ce que**, une classe étant affectée à ladite sous-séquence courante lors dudit codage, le groupe voisin codé déterminé pour la sous-séquence courante comprenant au moins une sous-séquence notée sous-séquence de dépendance, à laquelle est affectée une classe distincte de ladite classe affectée à la sous-séquence courante,
ledit flux est formé d'au moins deux sous-flux associés chacun à une desdites classes, chaque sous-flux portant des informations représentatives du codage entropique des symboles des sous-séquences appartenant à ladite classe,
et **en ce que** lesdites étapes d'initialisation, de décodage et de stockage pour des sous-séquences appartenant à une même classe sont mises en œuvre sous-flux par sous-flux, lesdits sous-flux étant traités en parallèle, lesdites étapes d'initialisation, de décodage et de stockage pour ladite au moins une sous-séquence de dépendance ayant été préalablement mises en œuvre.

12. Dispositif de codage d'au moins une image représentée par une séquence de symboles générée selon un ordre de parcours de codage prédéterminé, **caractérisé en ce qu'**il comprend :

- des moyens de détermination de sous-séquences dans ladite séquence de symboles, une sous-séquence correspondant à un regroupement prédéterminé de symboles ;
- et pour chaque sous-séquence déterminée, dite sous-séquence courante, :

- des moyens de détermination d'un groupe voisin, dit groupe voisin codé courant, comprenant au moins deux sous-séquences précédemment codées, parmi lesquelles au moins une sous-séquence du groupe voisin codé courant appartient à un groupe voisin codé déterminé pour une sous-séquence distincte de ladite sous-séquence courante, ladite sous-séquence distincte n'appartenant pas audit groupe voisin codé courant déterminé pour la sous-séquence courante et ladite sous-séquence courante n'appartenant pas au groupe voisin codé déterminé pour ladite sous-séquence distincte ;
- ladite sous-séquence distincte et la sous-séquence courante étant aptes à être décodées en parallèle,
- des moyens d'initialisation, pour chaque contexte associé à un symbole de ladite séquence de symboles à coder, d'une probabilité d'apparition dudit symbole associé audit contexte, dite probabilité d'apparition courante, en tenant compte d'au moins deux probabilités d'apparition dudit symbole, dites probabilités d'apparition connues, lesdites probabilités d'apparition connues ayant été stockées respectivement à la fin du codage entropique desdites au moins deux sous-séquences précédemment codées dudit groupe voisin codé courant ;
- des moyens de codage entropique successif desdits symboles de la sous-séquence courante selon ledit même ordre de parcours de codage prédéterminé utilisé pour générer la séquence de symboles, et pour chaque symbole codé, des moyens de mise à jour de ladite probabilité d'apparition courante pour le contexte associé audit symbole ;
- des moyens de stockage, pour chaque contexte associé à un symbole de ladite séquence de symbole codée, de ladite probabilité d'apparition courante associée audit contexte, après codage du dernier symbole de ladite sous-séquence courante.

13. Dispositif de décodage d'un flux représentatif d'au moins une image codée, **caractérisé en ce qu'**il comprend :

- des moyens d'obtention à partir dudit flux, d'au moins une sous-séquence, dite sous-séquence courante, ladite sous-séquence correspondant à un regroupement prédéterminé de symboles codés ;

et, pour ladite au moins une sous-séquence courante et pour chaque contexte associé à un symbole de la sous-séquence courante à décoder :

- des moyens d'initialisation d'une probabilité d'apparition dudit symbole associé audit contexte, dite probabilité d'apparition courante, en tenant compte d'au moins deux probabilités d'apparition dudit symbole, dites probabilités d'apparition connues, lesdits probabilités d'apparition connues ayant été stockées respectivement à la fin du décodage entropique d'au moins deux sous-séquences précédemment décodées d'un groupe voisin décodé déterminé pour la sous-séquence courante, un groupe voisin décodé comprenant lesdites au moins deux sous-séquences précédemment décodées, parmi lesquelles au moins une sous-séquence précédemment décodée appartient à un groupe voisin décodé déterminé pour une sous-séquence distincte de ladite sous-séquence courante, ladite sous-séquence distincte n'appartenant pas audit groupe voisin codé déterminé pour la sous-séquence courante et ladite sous-séquence courante n'appartenant pas au groupe voisin codé déterminé pour ladite sous-séquence distincte ;

- ladite sous-séquence distincte et la sous-séquence courante étant aptes à être décodées en parallèle,
- des moyens de décodage entropique successif desdits symboles de la sous-séquence courante selon un même ordre de parcours de codage mis en œuvre lors d'une génération desdits symboles lors du codage de ladite image, et pour chaque symbole, des moyens de mise à jour de ladite probabilité d'apparition courante pour le contexte associé audit symbole décodé ;
- des moyens de stockage, pour chaque contexte associé à un symbole de ladite séquence de symbole codée, de ladite probabilité d'apparition courante associée audit contexte de la sous-séquence courante, après décodage du dernier symbole de ladite sous-séquence courante.

14. Programme d'ordinateur comportant des instructions pour l'exécution des étapes du procédé selon la revendication 1 ou la revendication 10, lorsque ledit programme est exécuté par un ordinateur.

15. Dispositif de transcodage d'au moins une image représentée par une séquence de symboles générée selon un ordre de parcours de codage prédéterminé et codée par un codeur entropique, **caractérisé en ce qu'**il comprend :

- des moyens de décodage entropique des symboles codés de ladite séquence, aptes à fournir une séquence de symboles décodés;
- un dispositif de codage entropique selon la revendication 12, apte à encoder les symboles de ladite séquence de symboles décodés.

**Patentansprüche**

1. Verfahren zur Codierung mindestens eines Bilds, das durch eine Sequenz von Symbolen dargestellt wird, die gemäß einer vorbestimmten Codierungsdurchlaufreihenfolge erzeugt (21) wird, **dadurch gekennzeichnet, dass** es die folgenden Schritte umfasst:

- Bestimmen (22) von Untersequenzen in der Sequenz von Symbolen, wobei eine Untersequenz einer vorbestimmten Gruppierung von Symbolen entspricht;
- wobei die folgenden Unterschritte für jede bestimmte Untersequenz, aktuelle Untersequenz genannt, durchgeführt werden:
- Bestimmen (231) einer Nachbargruppe, aktuelle codierte Nachbargruppe genannt, die mindestens zwei zuvor codierte Untersequenzen umfasst, von denen mindestens eine Untersequenz der aktuellen codierten Nachbargruppe zu einer codierten Nachbargruppe gehört, die für eine Untersequenz bestimmt wird, die von der aktuellen Untersequenz verschieden ist, wobei die verschiedene Untersequenz nicht zu der aktuellen codierten Nachbargruppe gehört, die für die aktuelle Untersequenz bestimmt wird, und die aktuelle Untersequenz nicht zu der codierten Nachbargruppe gehört, die für die verschiedene Untersequenz bestimmt wird;
- wobei die verschiedene Untersequenz und die aktuelle Untersequenz geeignet sind, parallel decodiert zu werden,
- Initialisieren (232), für jeden Kontext, der einem Symbol der zu codierenden Sequenz von Symbolen zugeordnet ist, einer Auftrittswahrscheinlichkeit des Symbols, das dem Kontext zugeordnet ist, aktuelle Auftrittswahrscheinlichkeit genannt, unter Berücksichtigung mindestens zweier Auftrittswahrscheinlichkeiten des Symbols, bekannte Auftrittswahrscheinlichkeiten genannt, wobei die bekannten Auftrittswahrscheinlichkeiten jeweils am Ende des entropischen Codierens der mindestens zwei zuvor codierten Untersequenzen der aktuellen codierten Nachbargruppe gespeichert wurden;
- entropisches Codieren (233) der Symbole der aktuellen Untersequenz nacheinander gemäß derselben vorbestimmten Codierungsdurchlaufreihenfolge, die dafür genutzt wird, die Sequenz von Symbolen zu erzeugen, und für jedes codierte Symbol Aktualisieren der aktuellen Auftrittswahrscheinlichkeit für den Kontext, der dem Symbol zugeordnet ist;
- Speichern (234), für jeden Kontext, der einem Symbol der codierten Symbolsequenz zugeordnet ist, der aktuellen Auftrittswahrscheinlichkeit, die dem Kontext zugeordnet ist, nach Codierung des letzten Symbols der aktuellen Untersequenz.

2. Codierungsverfahren nach Anspruch 1, wobei der Schritt des Erzeugens einer Sequenz von Symbolen mithilfe einer blockweisen Codierung erhalten wird, wobei das Verfahren **dadurch gekennzeichnet ist, dass** die vorbestimmte Gruppierung von Symbolen einer Gruppierung von Blöcken fester Größe entspricht.

3. Codierungsverfahren nach Anspruch 2, **dadurch gekennzeichnet, dass** sich die aktuelle codierte Nachbargruppe in einem Rechteck befindet, das einerseits vom ersten codierten Block des Bilds gemäß der vorbestimmten Codierungsdurchlaufreihenfolge und andererseits von der Gruppierung von Blöcken, die die aktuelle Untersequenz bilden, begrenzt ist.

4. Codierungsverfahren nach Anspruch 3, **dadurch gekennzeichnet, dass** die mindestens zwei Gruppierungen von Blöcken, die die mindestens zwei zuvor codierten Untersequenzen der aktuellen codierten Nachbargruppe bilden, an die Gruppierung von Blöcken, die die aktuelle Untersequenz bilden, angrenzen.

5. Codierungsverfahren nach Anspruch 1, **dadurch gekennzeichnet, dass** der Schritt des Initialisierens der Auftrittswahrscheinlichkeit einen Wert zuweist, der gleich einer Kombination der bekannten Auftrittswahrscheinlichkeiten ist, die mindestens zwei zuvor codierten Untersequenzen der aktuellen codierten Nachbargruppe zugeordnet sind.

6. Codierungsverfahren nach Anspruch 5, **dadurch gekennzeichnet, dass**, wenn der Schritt des Erzeugens einer Sequenz von Symbolen mithilfe einer blockweisen Codierung erhalten wird, und die vorbestimmte Gruppierung von Symbolen einer Gruppierung von Blöcken fester Größe entspricht, die Kombination die bekannten Auftrittswahrscheinlichkeiten berücksichtigt, die einer ersten Untersequenz der aktuellen codierten Nachbargruppe, die sich links von der aktuellen Untersequenz befindet, und einer zweiten Untersequenz der aktuellen codierten Nachbargruppe, die sich über der aktuellen Untersequenz befindet, zugeordnet sind.

7. Codierungsverfahren nach Anspruch 1, **dadurch gekennzeichnet, dass** es ebenfalls einen Schritt des Bestimmens eines Vertrauensmaßes umfasst, das der aktuellen Auftrittswahrscheinlichkeit nach Codierung des letzten Symbols der aktuellen Untersequenz zugewiesen wird.

8. Codierungsverfahren nach Anspruch 7, **dadurch gekennzeichnet, dass** der Schritt des Initialisierens der aktuellen Auftrittswahrscheinlichkeit einen Wert zuweist, der gleich einem Mittelwert der bekannten Auftrittswahrscheinlichkeiten ist, die den Untersequenzen der aktuellen codierten Nachbargruppe zugeordnet sind, die jeweils mit einem Vertrauensmaß gewichtet werden, das beim Schritt des Bestimmens bestimmt wird.

9. Codierungsverfahren nach Anspruch 1, **dadurch gekennzeichnet, dass** es Folgendes umfasst:

- einen Schritt des Definierens mindestens zweier Klassen von Untersequenzen von Symbolen;
- einen Schritt des Zuweisens einer Klasse, aktuelle Klasse genannt, an die aktuelle Untersequenz, wobei die aktuelle Untersequenz in ihrer aktuellen codierten Nachbargruppe mindestens eine zuvor codierte Untersequenz aufweist, die mit Abhängigkeits-Untersequenz bezeichnet ist, welcher eine Klasse zugewiesen wird, die von der aktuellen Klasse verschieden ist;
- einen Schritt des Erzeugens eines Unterstroms pro Klasse, wobei jeder Unterstrom Informationen trägt, die für die entropische Codierung der Symbole der Untersequenzen repräsentativ sind, die zu der Klasse gehören.

10. Verfahren zur Decodierung eines Stroms, der für mindestens ein codiertes Bild repräsentativ ist, **dadurch gekennzeichnet, dass** es die folgenden Schritte umfasst:

- Erhalten (41), anhand des Stroms, mindestens einer Untersequenz, aktuelle Untersequenz genannt, wobei die Untersequenz einer vorbestimmten Gruppierung von codierten Symbolen entspricht;

und, für die mindestens eine aktuelle Untersequenz und für jeden Kontext, der einem Symbol der zu decodierenden aktuellen Untersequenz zugeordnet ist:

- Initialisieren (42) einer Auftrittswahrscheinlichkeit des Symbols, das dem Kontext zugeordnet ist, aktuelle Auftrittswahrscheinlichkeit genannt, unter Berücksichtigung mindestens zweier Auftrittswahrscheinlichkeiten des Symbols, bekannte Auftrittswahrscheinlichkeiten genannt, wobei die bekannten Auftrittswahrscheinlichkeiten jeweils am Ende des entropischen Decodierens mindestens zweier zuvor decodierter Untersequenzen einer decodierten Nachbargruppe gespeichert wurden, die für die aktuelle Untersequenz bestimmt wird, wobei eine decodierte Nachbargruppe die mindestens zwei zuvor decodierten Untersequenzen umfasst, von denen mindestens eine zuvor decodierte Untersequenz zu einer decodierten Nachbargruppe gehört, die für eine Untersequenz bestimmt wird, die von der aktuellen Untersequenz verschieden ist, wobei die verschiedene Untersequenz nicht zur aktuellen codierten Nachbargruppe gehört, die für die aktuelle Untersequenz bestimmt wird, und die aktuelle Untersequenz nicht zur codierten Nachbargruppe gehört, die für die verschiedene Untersequenz bestimmt wird;

- wobei die verschiedene Untersequenz und die aktuelle Untersequenz geeignet sind, parallel decodiert zu werden,

- entropisches Decodieren (43) der Symbole der aktuellen Untersequenz nacheinander gemäß einer selben Codierungsdurchlaufreihenfolge, die bei einer Erzeugung der Symbole beim Codieren des Bilds eingesetzt wird, und für jedes Symbol Aktualisieren der aktuellen Auftrittswahrscheinlichkeit für den Kontext, der dem decodierten Symbol zugeordnet ist;

- Speichern (44), für jeden Kontext, der einem Symbol der codierten Symbolsequenz zugeordnet ist, der aktuellen Auftrittswahrscheinlichkeit, die dem Kontext der aktuellen Untersequenz zugeordnet ist, nach Codierung des letzten Symbols der aktuellen Untersequenz.

11. Codierungsverfahren nach Anspruch 10, **dadurch gekennzeichnet, dass**, wobei eine Klasse während des Codierens der Untersequenz zugewiesen wird, die codierte Nachbargruppe, die für die aktuelle Untersequenz bestimmt wird, umfassend mindestens eine Untersequenz, die mit Abhängigkeits-Untersequenz bezeichnet ist, der eine Klasse zugewiesen wird, die von der Klasse verschieden ist, die der aktuellen Untersequenz zugewiesen wird, der Strom von mindestens zwei Unterströmen gebildet ist, die jeweils einer der Klassen zugewiesen sind, wobei jeder Unterstrom Informationen trägt, die für die entropische Codierung der Symbole der Untersequenzen repräsentativ sind, die zu der Klasse gehören, und dadurch, dass die Schritte des Initialisierens, Decodierens und Speicherns für Untersequenzen, die zu einer selben Klasse gehören, Unterstrom für Unterstrom durchgeführt werden, wobei die Unterströme parallel verarbeitet werden,

wobei die Schritte des Initialisierens, Decodierens und Speicherns für die mindestens eine Abhängigkeits-Untersequenz zuvor durchgeführt wurden.

12. Vorrichtung zur Codierung mindestens eines Bilds, das durch eine Sequenz von Symbolen dargestellt wird, die gemäß einer vorbestimmten Codierungsdurchlaufreihenfolge erzeugt wird, **dadurch gekennzeichnet, dass** sie Folgendes umfasst:

- Mittel zum Bestimmen von Untersequenzen in der Sequenz von Symbolen, wobei eine Untersequenz einer vorbestimmten Gruppierung von Symbolen entspricht;

- und für jede bestimmte Untersequenz, aktuelle Untersequenz genannt:

- Mittel zum Bestimmen einer Nachbargruppe, aktuelle codierte Nachbargruppe genannt, die mindestens zwei zuvor codierte Untersequenzen umfasst, von denen mindestens eine Untersequenz der aktuellen codierten Nachbargruppe zu einer codierten Nachbargruppe gehört, die für eine Untersequenz bestimmt wird die von der aktuellen Untersequenz verschieden ist, wobei die verschiedene Untersequenz nicht zu der aktuellen codierten Nachbargruppe gehört, die für die aktuelle Untersequenz bestimmt wird, und die aktuelle Untersequenz nicht zu der codierten Nachbargruppe gehört, die für die verschiedene Untersequenz bestimmt wird;

- wobei die verschiedene Untersequenz und die aktuelle Untersequenz geeignet sind, parallel decodiert zu werden,

- Mittel zum Initialisieren, für jeden Kontext, der einem Symbol der zu codierenden Sequenz von Symbolen zugeordnet ist, einer Auftrittswahrscheinlichkeit des Symbols, das dem Kontext zugeordnet ist, aktuelle Auftrittswahrscheinlichkeit genannt, unter Berücksichtigung mindestens zweier Auftrittswahrscheinlichkeiten des Symbols, bekannte Auftrittswahrscheinlichkeiten genannt, wobei die bekannten Auftrittswahrscheinlichkeiten jeweils am Ende des entropischen Codierens der mindestens zwei zuvor codierten Untersequenzen der aktuellen codierten Nachbargruppe gespeichert wurden;

- Mittel zum entropischen Codieren der Symbole der aktuellen Untersequenz nacheinander gemäß derselben vorbestimmten Codierungsdurchlaufreihenfolge, die dafür genutzt wird, die Sequenz von Symbolen zu erzeugen, und für jedes codierte Symbol Mittel zum Aktualisieren der aktuellen Auftrittswahrscheinlichkeit für den Kontext, der dem Symbol zugeordnet ist;

- Mittel zum Speichern, für jeden Kontext, der einem Symbol der codierten Symbolsequenz zugeordnet ist, der aktuellen Auftrittswahrscheinlichkeit, die dem Kontext zugeordnet ist, nach Codierung des letzten Symbols der aktuellen Untersequenz.

13. Vorrichtung zur Decodierung eines Stroms, der für mindestens ein codiertes Bild repräsentativ ist, **dadurch gekennzeichnet, dass** sie Folgendes umfasst:

- Mittel zum Erhalten, anhand des Stroms, mindestens einer Untersequenz, aktuelle Untersequenz genannt, wobei die Untersequenz einer vorbestimmten Gruppierung von codierten Symbolen entspricht;

und, für die mindestens eine aktuelle Untersequenz und für jeden Kontext, der einem Symbol der zu decodierenden aktuellen Untersequenz zugeordnet ist:

- Mittel zum Initialisieren einer Auftrittswahrscheinlichkeit des Symbols, das dem Kontext zugeordnet ist, aktuelle Auftrittswahrscheinlichkeit genannt, unter Berücksichtigung mindestens zweier Auftrittswahrscheinlichkeiten des Symbols, bekannte Auftrittswahrscheinlichkeiten genannt, wobei die bekannten Auftrittswahrscheinlichkeiten jeweils am Ende des entropischen Decodierens mindestens zweier zuvor decodierter Untersequenzen einer decodierten Nachbargruppe gespeichert wurden, die für die aktuelle Untersequenz bestimmt wird, wobei eine decodierte Nachbargruppe die mindestens zwei zuvor decodierten Untersequenzen umfasst, von denen mindestens eine zuvor decodierte Untersequenz zu einer decodierten Nachbargruppe gehört, die für eine Untersequenz bestimmt wird, die von der aktuellen Untersequenz verschieden ist, wobei die verschiedene Untersequenz nicht zur codierten Nachbargruppe gehört, die für die aktuelle Untersequenz bestimmt wird, und die aktuelle Untersequenz nicht zur codierten Nachbargruppe gehört, die für die verschiedene Untersequenz bestimmt wird;
- wobei die verschiedene Untersequenz und die aktuelle Untersequenz geeignet sind, parallel decodiert zu werden,
- Mittel zum entropischen Decodieren der Symbole der aktuellen Untersequenz nacheinander gemäß einer selben Codierungsdurchlaufreihenfolge, die bei einer Erzeugung der Symbole beim Codieren des Bilds eingesetzt wird, und für jedes Symbol Mittel zum Aktualisieren der aktuellen Auftrittswahrscheinlichkeit für den Kontext, der dem decodierten Symbol zugeordnet ist;
- Mittel zum Speichern, für jeden Kontext, der einem Symbol der codierten Symbolsequenz zugeordnet ist, der aktuellen Auftrittswahrscheinlichkeit, die dem Kontext der aktuellen Untersequenz zugeordnet ist, nach Codierung des letzten Symbols der aktuellen Untersequenz.

14. Computerprogramm, aufweisend Anweisungen für die Ausführung der Schritte des Verfahrens nach Anspruch 1 oder 10, wenn das Programm von einem Computer ausgeführt wird.

15. Vorrichtung zur Transcodierung mindestens eines Bilds, das durch eine Sequenz von Symbolen dargestellt wird, die gemäß einer vorbestimmten Codierungsdurchlaufreihenfolge erzeugt und von einem entropischen Codierer codiert wird, **dadurch gekennzeichnet, dass** sie Folgendes umfasst:

- Mittel zum entropischen Decodieren der codierten Symbole der Sequenz, die geeignet sind, eine Sequenz von decodierten Symbolen bereitzustellen;
- eine Vorrichtung zur entropischen Codierung nach Anspruch 12, die geeignet ist, die Symbole der Sequenz von decodierten Symbolen zu codieren.

**Claims**

1. Method for coding at least one image represented by a sequence of symbols generated (21) according to a predetermined coding scan order, **characterized in that** it comprises the following steps:

- determining (22) sub-sequences in said sequence of symbols, a sub-sequence corresponding to a predetermined grouping of symbols;
- the following sub-steps being carried out for each determined sub-sequence, called current sub-sequence:

- determining (231) a neighbouring group, called current coded neighbouring group, comprising at least two previously coded sub-sequences, among which at least one sub-sequence of the current coded neighbouring group belongs to a coded neighbouring group determined for a sub-sequence distinct from said current sub-sequence, said distinct sub-sequence not belonging to said current coded neighbouring group determined for the current sub-sequence and said current sub-sequence not belonging to the coded neighbouring group determined for said distinct sub-sequence;
- said distinct sub-sequence and the current sub-sequence being capable of being decoded in parallel;
- initializing (232), for each context associated with a symbol of said sequence of symbols to be coded, a probability of appearance of said symbol associated with said context, called current probability of appearance, taking into account at least two probabilities of appearance of said symbol, called known probabilities of appearance, said known probabilities of appearance having been stored, respectively, at the end of the entropy coding of said at least two previously coded sub-sequences of said current coded neighbouring group;
- successively entropy coding (233) said symbols of the current sub-sequence according to said same predetermined coding scan order used to generate the sequence of symbols, and, for each symbol coded, updating said current probability of appearance for the context associated with said symbol;
- storing (234), for each context associated with a symbol of said coded sequence of symbols, said current probability of appearance associated with said context, after coding the last symbol of said current sub-sequence.

2. Coding method according to Claim 1, wherein the step of generating a sequence of symbols is obtained using block coding, said method being **characterized in that** the predetermined grouping of symbols corresponds to a grouping of blocks of fixed size.

3. Coding method according to Claim 2, **characterized in that** said current coded neighbouring group is located in a rectangle delimited on the one hand by the first coded block of the image according to the predetermined coding scan order and on the other hand by the grouping of blocks constituting the current sub-sequence.

4. Coding method according to Claim 3, **characterized in that** said at least two groupings of blocks constituting said at least two previously coded sub-sequences of said current coded neighbouring group are adjacent to the grouping of blocks constituting the current sub-sequence.

5. Coding method according to Claim 1, **characterized in that** said initialization step assigns said current probability of appearance a value equal to a combination of the known probabilities of appearance that are associated with at least two previously coded sub-sequences of said current coded neighbouring group.

6. Coding method according to Claim 5, **characterized in that**, when the step of generating a sequence of symbols is obtained using block coding, and the predetermined grouping of symbols corresponds to a grouping of blocks of fixed size, said combination takes account of the known probabilities of appearance that are associated with a first sub-sequence of said current coded neighbouring group, located to the left of said current sub-sequence, and with a second sub-sequence of said current coded neighbouring group, located above said current sub-sequence.

7. Coding method according to Claim 1, **characterized in that** it also comprises a step of determining a confidence measurement assigned to said current probability of appearance after coding the last symbol of said current sub-sequence.

8. Coding method according to Claim 7, **characterized in that** said initialization step assigns said current probability of appearance a value equal to an average of the known probabilities of appearance that are associated with said sub-sequences of said current coded neighbouring group, each weighted by a confidence measure determined during said determination step.

9. Coding method according to Claim 1, **characterized in that** it comprises:

- a step of defining at least two classes of sub-sequences of symbols;
- a step of assigning a class, called current class, to said current sub-sequence, said current sub-sequence having in its current coded neighbouring group at least one previously coded sub-sequence, denoted dependency sub-sequence, to which a class distinct from said current class is assigned;
- a step of generating a sub-stream per class, each sub-stream carrying information representative of the entropy coding of the symbols of the sub-sequences belonging to said class.

10. Method for decoding a stream representative of at least one coded image, **characterized in that** it comprises the following steps:

- obtaining (41), from said stream, at least one sub-sequence, called current sub-sequence, said sub-sequence corresponding to a predetermined grouping of coded symbols;

and, for said at least one current sub-sequence and for each context that is associated with a symbol of the current sub-sequence to be decoded:

- initializing (42) a probability of appearance of said symbol associated with said context, called the current probability of appearance, taking into account at least two probabilities of appearance of said symbol, called known probabilities of appearance, said known probabilities of appearance having been stored, respectively, at the end of the entropy decoding of at least two previously decoded sub-sequences of a decoded neighbouring group determined for the current sub-sequence, a decoded neighbouring group comprising said at least two previously decoded sub-sequences, among which at least one previously decoded sub-sequence belongs to a decoded neighbouring group determined for a sub-sequence distinct from said current sub-sequence, associated with a sub-sequence distinct from said current sub-sequence, said distinct sub-sequence not belonging to said current coded neighbouring group determined for the current sub-sequence and said current sub-sequence not belonging to the coded neighbouring group determined for said distinct sub-sequence;
- said distinct sub-sequence and the current sub-sequence being capable of being decoded in parallel;
- successively entropy decoding (43) said symbols of the current sub-sequence according to one and the same coding scan order implemented during generation of said symbols during the coding of said image, and for each symbol, updating said current probability of appearance for the context associated with said decoded symbol;
- storing (44), for each context associated with a symbol of said coded sequence of symbols, said current probability of appearance associated with said context of the current sub-sequence, after decoding the last symbol of said current sub-sequence.

11. Decoding method according to Claim 10, **characterized in that**, a class being assigned to said current sub-sequence during said coding, the coded neighbouring group determined for the current sub-sequence comprising at least one sub-sequence denoted dependency sub-sequence, to which is assigned a class distinct from said current class assigned to the current sub-sequence,
said stream is formed of at least two sub-streams each associated with one of said classes, each sub-stream carrying information representative of the entropy coding of the symbols of the sub-sequences belonging to said class,
and **in that** said steps of initialization, decoding and storage for sub-sequences belonging to one and the same class are implemented sub-stream by sub-stream, said sub-streams being processed in parallel,
said steps of initialization, decoding and storage for said at least one dependency sub-sequence having been implemented previously.

12. Device for coding at least one image represented by a sequence of symbols generated according to a predetermined coding scan order, **characterized in that** it comprises:

- means for determining sub-sequences in said sequence of symbols, a sub-sequence corresponding to a predetermined grouping of symbols;
- and for each determined sub-sequence, called current sub-sequence:

- means for determining a neighbouring group, called current coded neighbouring group, comprising at least two previously coded sub-sequences, among which at least one sub-sequence of the current coded neighbouring group belongs to a coded neighbouring group determined for a sub-sequence distinct from said current sub-sequence, said distinct sub-sequence not belonging to said current coded neighbouring group determined for the current sub-sequence and said current sub-sequence not belonging to the coded neighbouring group determined for said distinct sub-sequence;
- said distinct sub-sequence and the current sub-sequence being capable of being decoded in parallel;
- means for initializing, for each context associated with a symbol of said sequence of symbols to be coded, a probability of appearance of said symbol associated with said context, called current probability of appearance, taking into account at least two probabilities of appearance of said symbol, called known probabilities of appearance, said known probabilities of appearance having been stored, respectively, at the end of the entropy coding of said at least two previously coded sub-sequences of said current coded neighbouring group;
- means for successively entropy coding said symbols of the current sub-sequence according to said same predetermined coding scan order used to generate the sequence of symbols, and, for each symbol coded, means for updating said current probability of appearance for the context associated with said symbol;
- means for storing, for each context associated with a symbol of said coded sequence of symbols, said current probability of appearance associated with said context, after coding the last symbol of said current sub-sequence.

**13.** Device for decoding a stream representative of at least one coded image, **characterized in that** it comprises:

- means for obtaining, from said stream, at least one sub-sequence, called current sub-sequence, said sub-sequence corresponding to a predetermined grouping of coded symbols;

and, for said at least one current sub-sequence and for each context that is associated with a symbol of the current sub-sequence to be decoded:

- means for initializing a probability of appearance of said symbol associated with said context, called the current probability of appearance, taking into account at least two probabilities of appearance of said symbol, called known probabilities of appearance, said known probabilities of appearance having been stored, respectively, at the end of the entropy decoding of at least two previously decoded sub-sequences of a decoded neighbouring group determined for the current sub-sequence, a decoded neighbouring group comprising said at least two previously decoded sub-sequences, among which at least one previously decoded sub-sequence belongs to a decoded neighbouring group determined for a sub-sequence distinct from said current sub-sequence, said distinct sub-sequence not belonging to said current coded neighbouring group determined for the current sub-sequence and said current sub-sequence not belonging to the coded neighbouring group determined for said distinct sub-sequence;
- said distinct sub-sequence and the current sub-sequence being capable of being decoded in parallel;
- means for successively entropy decoding said symbols of the current sub-sequence according to one and the same coding scan order implemented during generation of said symbols during the coding of said image, and for each symbol, means for updating said current probability of appearance for the context associated with said decoded symbol;
- means for storing, for each context associated with a symbol of said coded sequence of symbols, said current probability of appearance associated with said context of the current sub-sequence, after decoding the last symbol of said current sub-sequence.

**14.** Computer program comprising instructions for the execution of the steps of the method according to Claim 1 or Claim 10, when said program is executed by a computer.

**15.** Device for transcoding at least one image represented by a sequence of symbols generated according to a predetermined coding scan order and coded by an entropy coder, **characterized in that** it comprises:

- means for entropy decoding the coded symbols of said sequence, capable of providing a sequence of decoded symbols;
- an entropy coding device according to Claim 12, capable of encoding the symbols of said sequence of decoded symbols.

**Figure 1**

Image

**Figure 2a**

**Figure 2b**

**Figure 3**

**Figure 4a**

41 — GET

42 — INIT

43 — DECODE

44 — SAVE

**Figure 4b**

$s\text{-}f_1$

$42_1$ — INIT

$43_1$ — DECODE

$44_1$ — SAVE

$s\text{-}f_j$

$42_j$ — INIT

$43_j$ — DECODE

$44_j$ — SAVE

$s\text{-}f_i$

INIT — $42_i$

$43_i$ — DECODE

$44_i$ — SAVE

Figure 5a

Figure 5b

|  |  |  |  |  |  | 0 |  |  |  |  |  | 1 |  |  |  |  |
|---|---|---|---|---|---|---|---|---|---|---|---|---|---|---|---|---|

| 0 | 1 | 2 | 3 | 4 | 5 | 6 | 7 | 8 | 9 | 1 0 | 1 1 |
|---|---|---|---|---|---|---|---|---|---|---|---|
| 1 | 2 | 3 | 4 | 5 | 6 | 7 | 8 | 9 | 1 0 | 1 1 | 1 2 |
| 6 | 7 | 8 | 9 | 1 0 | 1 1 | 1 2 | 1 3 | 1 4 | 1 5 | 1 6 | 1 7 |
| 7 | 8 | 9 | 1 0 | 1 1 | 1 2 | 1 3 | 1 4 | 1 5 | 1 6 | 1 7 | 1 8 |
| 1 2 | 1 3 | 1 4 | 1 5 | 1 6 | 1 7 | 1 8 | 1 9 | 2 0 | 2 1 | 2 2 | 2 3 |
| 1 3 | 1 4 | 1 5 | 1 6 | 1 7 | 1 8 | 1 9 | 2 0 | 2 1 | 2 2 | 2 3 | 2 4 |
| 1 8 | 1 9 | 2 0 | 2 1 | 2 2 | 2 3 | 2 4 | 2 5 | 2 6 | 2 7 | 2 8 | 2 9 |
| 1 9 | 2 0 | 2 1 | 2 2 | 2 3 | 2 4 | 2 5 | 2 6 | 2 7 | 2 8 | 2 9 | 3 0 |

2

4

3

5

**Figure 5c**

**Figure 6**

71

μP

70

M

72

Pg

**Figure 7**

81

82

DEC

83

ENC

N

**Figure 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009168868 A1

**Littérature non-brevet citée dans la description**

- **J. RISSANEN ; G. G. LANGDON JR.** Universal modeling and coding. *IEEE Trans. Inform. Theory,* Janvier 1981, vol. IT-27, 12-23